# EUROPEAN PATENT APPLICATION

(11) **EP 1 249 931 A2**
(43) Date of publication of application: **16.10.2002**
(21) Application number: 02252110.8
(22) Date of filing: 25.03.2002
(51) Int. Cl.: H03F 1/32

(54) **Auto-adaptive pre-distortion scheme employing parametric modelling**

(30) Priority: 27.03.2001 GB 0107553
(71) Applicant: Pace Micro Technology PLC, Shipley, West Yorkshire BD18 3LF (GB)
(72) Inventor: Price, Caleb, Leeds, LS12 2PG (GB)
(74) Representative: Wood, Graham

(57) **Abstract**

The invention to which this application relates is to provide an improvement in the operation of a power amplifier especially, although not necessarily exclusively, of the type used in data transmitters and modems. The invention allows the utilisation of pre-distortion techniques to pre-distort the digital baseband transmit signal into the PA. The pre-distortion occurs with respect to feedback data received via a feedback loop from the output of the PA, rather than referring to look-up tables as is conventionally the case. This therefore allows the utilisation of a low cost low power PA rather than the conventional requirement for a high power and more expensive PA to be used due to the need for a high degree of linearity to be achieved.

## Description

The present invention relates to the use of an RF Power Amplifier especially although not necessarily exclusively of the type used in data transmitters and a method to dynamically optimise the performance and efficiency of the same.

The operation of a Power Amplifier is inherently non-linear and thus can cause problems in the prediction of the operation of the same and indeed systems including the PA. Several well established techniques exist to improve the linearity of an inherently non-linear PA. The most popular of these are Cartesian Loop and Pre-Distortion. Cartesian Loops achieve improvement in linearity by downconverting a sample of the PA output, resolve to I and Q (in-phase and quadrature-phase) components, and comparing these signals to the corresponding baseband I and Q inputs to the transmitter. It is these resultant difference signals rather than the I and Q inputs themselves which are passed to the modulator, and then to the PA. By ensuring that the gain of the feedback path is very much greater than that of the PA, the overall system gain tends to that of the PA in linear region.

A major disadvantage of the Cartesian Loop system is that it inherently produces high levels of wideband noise. This is attributable to its closed-loop action coupled with the necessity to perform the comparison between input and sampled output at low signal levels. The Cartesian Loop's real-time closed loop architecture is also prone to instability problems, when subjected to high levels of external interference. As a result the use of Cartesian Loop systems is generally restricted to the amplification of low-bandwidth signals (tens of kHz). Higher bandwidth implementations have been developed 1MHz or more) but their effectiveness is greatly diminished.

Pre-distortion is the other commonly used technique to "linearise" radio frequency (RF) Power Amplifiers (PA) in order to optimise their performance and efficiency. Linearity is an important characteristic for PAs used to transmit data signals which contain some element of amplitude modulation, such as QAM (Quadrature Amplitude Modulation). For such systems, a class-A category of PA is normally used. This category of PA generally provides good linearity characteristics for low signal levels, but, as the drive power increases, the PA gain value tends to reduce, thus distorting the transmitted signal and producing significant levels of intermodulation products. Furthermore, the drive-power dependent non-linear characteristic of the PA typically varies as a function of the environmental conditions and ageing.

The act or method of pre-distortion helps to overcome the problem of non-linearity in the performance of the PA by conditioning the signal which is input into the PA with a non-linear characteristic. This non-linear characteristic is controlled so as to be the inverse of the known non-linear characteristic of the PA. The desired net result is a near cancellation of the non-linearity, providing the pre-conditioning method performed closely matches the PA's inverse characteristic.

The known, conventional pre-distortion techniques which are used utilise historical data held in memory known as "look-up tables". A look up table is a tabular memory of information which allows a predetermined parameter, or parameters of operation, which is identified as a result of matching the same with a particular actual measured characteristic of a known component. That is in practise the look-up table and can be employed to map the amplitudes of measured discrete drive samples of the PA to their corresponding "pre-distorted" levels. However, a known problem with this approach is that the look-up tables have to be relatively large in order to maintain the signal resolution e.g. for a signal generated by a 12-bit Digital to Analogue Converter (DAC), the size of the look-up table is required to be 2^12 x 12 bits which requires a significant amount of data to be held and memory capacity to be provided.

One alternative is to use a much smaller look-up table and interpolate the data, but this requires a substantial amount of relatively expensive processing power.

In both prior art cases it is difficult and cumbersome to modify the look-up table to track the time-varying characteristics of the PA.

The aim of the invention is to use the technique of Pre-Distortion in an improved and efficient manner such that the adaption of the control system occurs without the need for reference to look up tables.

In a first aspect of the invention there is provided a control method for a Power Amplifier (PA), said control method for the operation of the PA adaptive in that a pre-distortion technique is utilised and characterised in that the digital baseband transmit signal into the PA is pre-conditioned with the inverse characteristics of the PA's operating characteristics, via a feed back path from the PA, said characteristics including a function of drive power and from which value the control system utilises an analytical parametric model to derive the required pre-distortion of the digital baseband transmit signal.

In accordance with a preferred embodiment, rather than providing a discrete mapping between demanded and pre-distorted signal amplitude levels, as with the look-up table approach, the method employs an analytical parametric model of the PA's characteristics to derive the required pre-distortion level and values. The advantages are twofold in that the memory requirements are almost negligible since only a small number of parameters need to be stored and furthermore algorithms can be used to modify the model parameters as the feedback from the PA output varies and thus can track the PAs time-varying characteristics.

In one embodiment of the invention the method employs a pair of polynomials (3^{rd} or 5^{th} order have been shown to be sufficient) to model the in-phase and quadrature-phase gain components of the PA respectively. Typically these gain components are modelled as functions of drive power.

The method typically utilises a feedback path, in one embodiment, an existing receive chain, to provide a digital baseband representation of the signal as it leaves the output of the PA. By taking the system delay into account, this value, the system delay and the original baseband transmit data are combined together and then processed to derive the coefficients values or model parameters of the in-phase and quadrature-phase polynomial models.

Typically an LMS (Least Mean Squared) optimisation algorithm is used to perform this task.

Preferably the coefficients are re-calculated as often as is deemed necessary to accurately match the PAs characteristics, and hence recalculation can be performed as the time varying characteristics of the PA components have an effect on the performance. Thus the method of the invention can always ensure that the same closely models the actual characteristics.

Preferably the digital baseband transmit data is then pre-distorted with the inverse of the in phase and quadrature phase polynomial models last calculated and hence representing the PA characteristics at that time.

In one embodiment a single iteration of a Newton-Raphson algorithm is used to invert the polynomials on a sample by sample basis.

In one embodiment the invention is employed in a wireless modem product and simulation tests show that, when applied, this invention allows the power capability of the PA to be reduced by a substantial amount, thereby providing considerable savings in the cost of associated components and heatsinks, in addition to the cost of the PA components themselves.

When employed in the modem the pre-distortion model resides in the IDU (In Door Unit) and intercepts the digital baseband output prior to D/A conversion. This is a "real" data stream (ie non-complex) and must therefore be converted to/from in-phase and quadrature-phase components inside the pre-distorter. The analogue baseband output of the IF section is down converted to a digital signal and fed for demodulation, and to the pre-distorter for PA model tracking in accordance with the invention.

Thus the invention can be achieved with no major architectural changes made to the existing system. The invention relies on the availability of signal feedback through the receiver during transmission.

In a further aspect of the invention there is provided a method for the control of a PA as part of data processing apparatus, said PA including a data transmit signal input into the PA and said PA data transmit signal is pre-distorted to improve the linearity of operation of the same characterised in that a parametric model is provided to provide the pre-distortion by generating inverse values of the in-phase and quadrature phase gain components of the PA which are added to the data transmit signal with a component representing the signal delay.

In one embodiment a feedback path from the PA output is fed to the model to allow the gain components to be calculated.

Typically the gain components are calculated at time intervals during operation of the PA to allow changes in the operation of the PA over time to be reflected in the gain component values.

A specific embodiment of the invention is now described with reference to the accompanying drawings; wherein
Figures 1, 2 and 3 are illustrative of the method of the invention applied to a Quadrature Amplitude Modulated (QAM) transmission system; and
Figure 4 illustrates a circuit diagram of one embodiment of the invention.

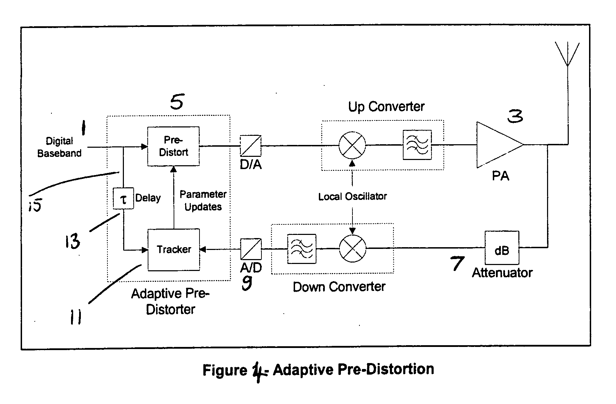

Referring firstly to Figure 4 there is shown a simplified representation of a transmitter incorporating the adaptive pre-distortion scheme of the invention. The complex digital baseband signal 1 is pre-distorted by a non-linear function which is the inverse of a model of the PA 3 transfer characteristics. The model 5 takes the form of a pair of polynomials representing the in-phase and quadrature-phase components of the PA's operating characteristics. An attenuated portion 7 of the transmitted signal is applied to a receiver strip and converted back to digital baseband 9. This is fed into the "tracker" module 11 together with a delayed version 13 of the original baseband signal. With the delay set precisely to that of the combined transmit and receive path, the accuracy of the PA model can be established. The feed back signal 15 is used to iterate the parameters of the model, i.e. the coefficients of the polynomials, using an LMS based algorithm and thus the model converges on the actual characteristics of the PA, as required in accordance with the invention.

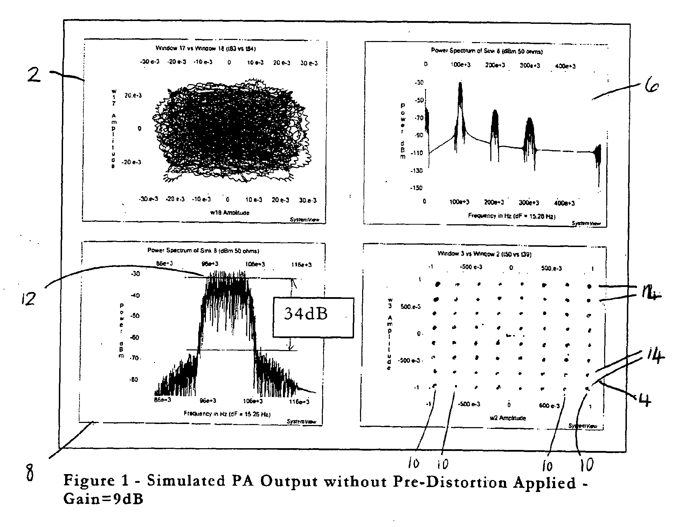

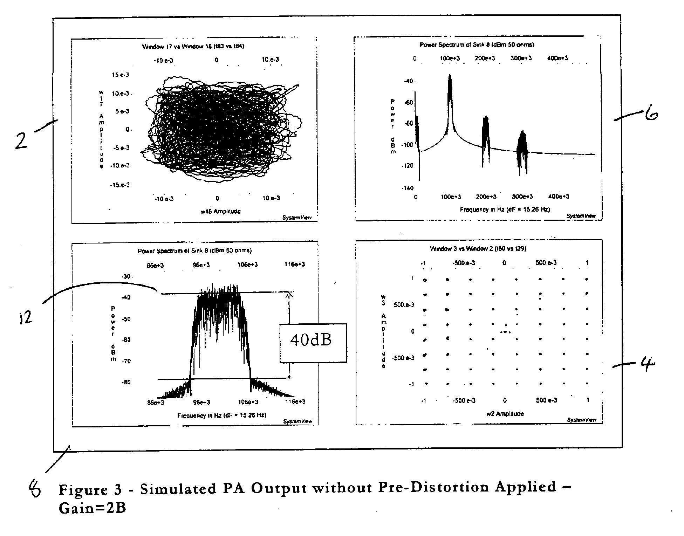

Figures 1, 2 and 3 represent a computer simulation of a QAM transmission system where each of the Figures 1-3 shows four separate plots. The top-left corner plot 2 shows a representation of the time-domain signal trajectory. The bottom-right plot 4 shows the same trajectory sampled at the symbol rate, thus revealing the QAM constellation. The top-right 6 and bottom-left 8 plots both show, respectively, wide and narrow band frequency domain representations of the output of the PA.

In **Error! Reference source not found.,** the PA is driven into its compression region by a signal of arbitrary power of value 9dB. Inspection of the constellation plot (bottom-right) reveals evidence of compression in that the outer constellation vertical and horizontal plot lines 10, 14 formed by the line of plots 14 are slightly curved. In the narrow-band spectral plot 8 (bottom-left), 3^{rd} order intermodulation products 12 are apparent at a level of -34dB relative to the peak signal level.

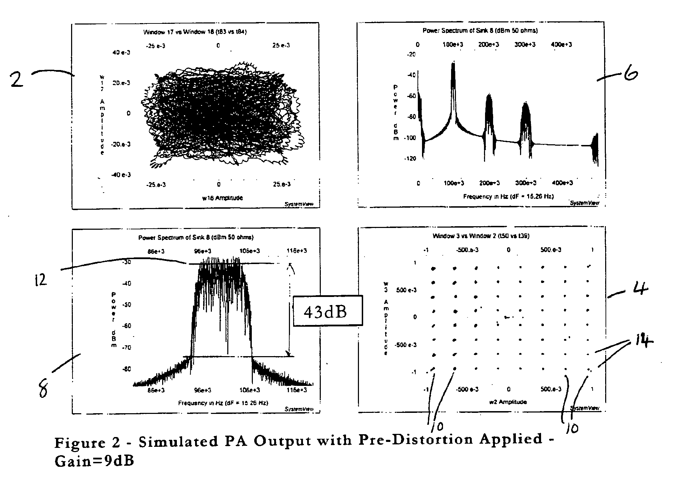

**Error! Reference source not found.** shows results of the same system simulation, but in this case a pre-distortion technique is applied. In this case the constellation lines 10, 14 are straighter and the 3^{rd} order intermodulation product levels 12 have dropped to become apparent at -43dB Thus Figure 2 illustrates the use of pre-distortion technique in accordance with the invention whereby an analytical parametric model is used to track the characteristics of the performance of the PA. The key to this is the monitoring of the feedback path from the PA and the co-operating of this with the original digital baseband input and the time delay.

For the results shown in **Error! Reference source not found.,** the use of pre-distortion of the invention is stopped, removed, and the drive power level reduced to a value of 2dB in an attempt to match the intermodulation level performance for the system with the pre-distortion of the invention applied as shown in Figure 2. It can be seen that even with a reduction of 7dB in drive power, the intermodulation performance illustrated by plot 8 is still inferior to the system with pre-distortion applied, as shown in Figure 2 by about 3dB.

Thus, in practical terms, this means that for a given intermodulation product performance, with pre-distortion applied, the power capability of the PA can be reduced by 7dB, and hence allow the use of lower power and hence cheaper PA's without affecting the performance and importantly achieving the required performance characteristics.

Thus the present invention results in lower implementation cost than other pre-distortion schemes and provides a very effective and efficient means of tracking changes in the PAs characteristics.

Thus there is provided the use of parametric models to track the time-varying non-linear characteristics of an RF Power Amplifier (PA).

## Claims

1. A control method for a power amplifier (PA) (3) said control method for the operation of the PA adaptive in that a pre-distortion technique is utilised and **characterised in that** the digital baseband transmit signal (1) into the PA is preconditioned with the inverse characteristics of the PA's operating characteristics, via a feedback path (7) from the PA, said characteristics including a function of drive power and from which value the control system utilises an analytical parametric model (5) to derive the required pre-distortion of the digital baseband transmit signal (1).

2. A method according to claim 1 **characterised in that** a pair of polynomials are utilised to model in-phase and quadrature-phase gain components of the PA.

3. A method according to claim 2 **characterised in that** the gain components are modelled as functions of drive power.

4. A method according to claim 2 **characterised in that** the pair of polynomials used are 3^{rd} or 5^{th} order polynomials.

5. A method according to claim 1 **characterised in that** the method utilises the feedback path to provide a digital baseband representation of the signal as it leaves the output of the PA.

6. A method according to claim 1 **characterised in that** a value for system delay is taken into account, to generate a delayed version (13) of the original digital baseband transmit signal, which is fed into the analytical parametric model.

7. A method according to claim 1 **characterised in that** the value for the system delay, the original baseband transmit data signal and the feedback path data are processed to derive the coefficient values or model parameters of the in-phase and quadrature-phase polynomial models.

8. A method according to claim 1 wherein a Least Mean Squared (LMS) optimisation algorithm is used to perform this task.

9. A method according to claim 1 wherein the predistortion coefficient values are recalculated at regular intervals so as to accurately match the PA operating characteristics at that instant.

10. A method according to claim 9 wherein the digital baseband transmit data input into the PA is pre-distorted with the values of the inverse of the in-phase and quadrature-phase polynomial models last calculated.

11. A method according to claim 1 wherein the single iteration of a Newton-Raphson algorithm is used to invert the polynomials on a sample by sample basis.

12. A method according to claim 1 wherein the method is employed in a wireless modem product.

13. A method for the control of a PA as part of data processing apparatus, said PA including a data transmit signal input into the PA and said PA data transmit signal is pre-distorted to improve the linearity of operation of the same **characterised in that** a parametric model is provided to provide the pre-distortion by generating inverse values of the in-phase and quadrature phase gain components of the PA which are added to the data transmit signal with a component representing the signal delay.

14. A method according to claim 13 **characterised in that** a feedback path from the PA output is fed to the model to allow the gain components to be calculated.

15. A method according to claim 13 **characterised in that** the gain components are calculated at time intervals during operation of the PA to allow changes in the operation of the PA over time to be reflected in the gain component values.
